**Europäisches Patentamt**

(19) **European Patent Office**

**Office européen des brevets**

(11) Numéro de publication: **0 092 489**
**B1**

## (12) FASCICULE DE BREVET EUROPEEN

(45) Date de publication du fascicule du brevet:
**07.01.88**

(21) Numéro de dépôt: **83400776.7**

(22) Date de dépôt: **19.04.83**

(51) Int. Cl.⁴: **F 21 Q 3/00, H 01 R 33/46**

(54) **Voyant lumineux pour circuits imprimés.**

(30) Priorité: **21.04.82 FR 8206834**

(43) Date de publication de la demande:
**26.10.83 Bulletin 83/43**

(45) Mention de la délivrance du brevet:
**07.01.88 Bulletin 88/1**

(84) Etats contractants désignés:
**BE DE GB IT LU NL SE**

(56) Documents cités:
**DE - A - 2 506 942**
**FR - A - 1 424 780**
**FR - A - 2 008 429**
**US - A - 3 065 335**

(73) Titulaire: **VIBRACHOC, 216 Les Bureaux de la Colline de Saint Cloud, F-92213 Saint Cloud (FR)**

(72) Inventeur: **Debrabander, Armand, 50 rue des Petites Fontaines, F-91490 Milly La Foret (FR)**

(74) Mandataire: **Lemoine, Michel et al, Cabinet Michel Lemoine 13 Boulevard des Batignolles, F-75008 Paris (FR)**

## Description

L'invention a trait à un voyant muni d'une source lumineuse et de moyens de fixation destinés à permettre sa fixation sur un circuit imprimé tout en assurant simultanément la continuité électrique avec au moins deux pistes du circuit destinées à alimenter le voyant, comportant un support isolant définissant un bord annulaire cylindrique dont le diamètre est légèrement inférieur au diamètre d'un poinçonnage correspondant pratiqué dans le circuit imprimé, ledit support étant muni, d'un côté dudit bord, d'un prolongement radial destiné à s'appuyer contre celle des faces du circuit imprimé qui ne présente pas lesdites pistes, ledit support supportant, de l'autre côté du bord annulaire, au moins deux languettes métalliques conductrices disposées sensiblement radialement et susceptibles d'être mises en contact avec les bornes de la source lumineuse supportée par ledit support, lesdites languettes dépassant radialement ledit bord annulaire pour former deux extrémités radiales susceptibles de traverser le poinçonnage pratiqué dans le circuit imprimé grâce à des encoches radiales du poinçonnage, la rotation du support amenant alors les extrémités des languettes au contact de la face du circuit imprimé portant les pistes avec une déformation élastique des languettes tendant à maintenir le voyant serré sur le circuit imprimé.

Les voyant connus de ce type (FR-A-1 424 780 et GB-A-1 464 598) ont un très grand encombrement dans le plan perpendiculaire à la carte qui les reçoit, ce qui constitue un inconvénient particulièrement gênant.

L'invention a pour but de remédier à cet inconvénient tout en fournissant un voyant qui sont de réalisation simple et facile et de mise en place particulièrement rapide.

A cet effet, l'invention a pour objet un voyant muni d'une source lumineuse et de moyens de fixation destinés à permettre sa fixation sur un circuit imprimé tout en assurant simultanément la continuité électrique avec au moins deux pistes du circuit destinées à alimenter le voyant, ledit voyant comportant un support isolant définissant un bord annulaire cylindrique dont le diamètre est légèrement inférieur au diamètre d'un poinçonnage correspondant pratiqué dans le circuit imprimé, ledit support étant muni à côté dudit bord, d'un prolongement radial destiné à s'appuyer contre celle des faces du circuit imprimé qui ne présente pas lesdites pistes, ledit support supportant, de l'autre côté du bord annulaire au moins deux languettes métalliques conductrices disposées sensiblement radialement et susceptibles d'être mises en contact avec les bornes de la source lumineuse supportée par ledit support, lesdites languettes dépassant radialement ledit bord annulaire pour former deux extrémités radiales susceptibles de traverser le poinçonnage pratiqué dans le circuit imprimé grâce à des encoches radiales du poinçonnage, la rotation du support amenant alors les extrémités des languettes au contact de la face du circuit imprimé portant les pistes avec une déformation élastique des languettes tendant à maintenir le voyant serré sur le circuit imprimé, caractérisé en ce que ledit support isolant présente la forme d'un disque aplati muni, au niveau de l'une de ses faces d'une collerette sensiblement circulaire s'étendant latéralement et sur son autre face de reliefs immobilisant des éléments métalliques de contact formant une partie centrale s'étendant obliquement vers le bas sur ladite surface et venant bloquer, sur le support, des fils libres de la source lumineuse disposée sur ladite face et former une continuité électrique entre lesdits fils et lesdites languettes.

Selon un mode de réalisation avantageux, les susdites extrémités des languettes sont inclinées de manière à former des rampes coopérant avec le circuit imprimé pour faire passer lesdites extrémités par-dessus le bord de l'encoche radiale de poinçonnage, puis au contact de la face correspondante du circuit imprimé.

De préférence encore, le voyant est muni de moyens d'immobilisation dans la position angulaire requise, lesquels comportent avantageusement des reliefs disposés radialement en relief par rapport auxdits bords cylindriques et angulairement décalés par rapport aux languettes élastiques de façon à venir s'encliqueter dans les encoches de poinçonnage du circuit imprimé, sous l'action de rappel élastique desdites languettes. Lesdits reliefs peuvent se raccorder auxdits prolongements radiaux par une rampe inclinée dans le sens de rotation inverse de celui permettant la mise en place du voyant sur le circuit imprimé.

D'autres avantages et caractéristiques de l'invention apparaîtront à la lecture de la description suivante, faite à titre d'exemple non limitatif et se référant au dessin annexé dans lequel:

La figure 1 représente schématiquement le dessus d'un voyant selon l'invention.

La figure 2 représente schématiquement le dessous de ce voyant.

La figure 3 représente une vue schématique en coupe selon la ligne III–III de la figure 1.

La figure 4 représente de profil ce dispositif.

La figure 5 représente de profil un relief de blocage de ce dispositif.

La figure 6 représente en plan un poinçonnage pratiqué dans une carte à circuits imprimés.

Le voyant selon l'invention, tel qu'il a été représenté, comporte tout d'abord un support 1, en matériau isolant, par exemple en matière plastique, présentant globalement la forme d'un disque aplati avec une face inférieure pratiquement circulaire 2, munie d'une creusure longitudinale 3, et une deuxième face opposée 4 destinée à recevoir les languettes et la source lumineuse, en l'occurrence une ampoule 5 présentant deux fils libres 6 et 7.

La périphérie du support 1 forme une collerette sensiblement circulaire 8 à partir de laquelle s'étend un bord annulaire cylindrique 9 dont la hauteur est, par exemple, égale à l'épaisseur du circuit imprimé destiné à recevoir le voyant. Du côté du bord 9, la collerette 8 présente, en deux emplacements diamétralement opposés, deux bossages ou reliefs radiaux 10 dont la face 11, disposée du côté anti-horaire, est abrupte et perpendiculaire au plan de la collerette 8 alors que l'autre face se poursuit par une rampe 12 rejoignant progressivement la collerette 8.

Du côté de sa face 4, le support 1 présente deux paires de deux bossages 13, deux bossages d'une paire laissant entre eux un passage radial, les deux passages ainsi formés étant alignés sur un diamètre perpendiculaire au diamètre rejoignant les rampes 12. Du côté centripète, les bossages 13 présentent chacun une rainure interne 14 au voisinage du bossage. Par ailleurs, la face 4 présente, sur sa partie centrale, un relief diamétralement allongé 15, dont la surface supérieure peut avantageusement être courbée de façon cylindrique concave pour s'adapter à la périphérie cylindrique de l'ampoule 5, ce relief 15 étant bordé par deux rainures parallèles 16, les différentes rainures 14 et 16 étant toutes parallèles.

On peut aussi venir mettre en place deux éléments métalliques de contact 17 présentant une partie rectangulaire et une languette 18 radiale. Chaque élément 17 présente, sur son bord orienté vers le relief central 15, deux découpes définissant deux pattes courtes latérales 19 et une patte centrale 20, la patte centrale 20 se dirigeant obliquement vers le bas et vers les rainures 16, alors que les pattes latérales 19 se dirigent davantage vers le haut, c'est-à-dire vers la partie supérieure des rainures 16.

Vers l'extérieur, les éléments 17 présentent, de part et d'autre de la languette 18, deux pattes 21 orientées obliquement vers le haut en direction des rainures 14 des bossages 13.

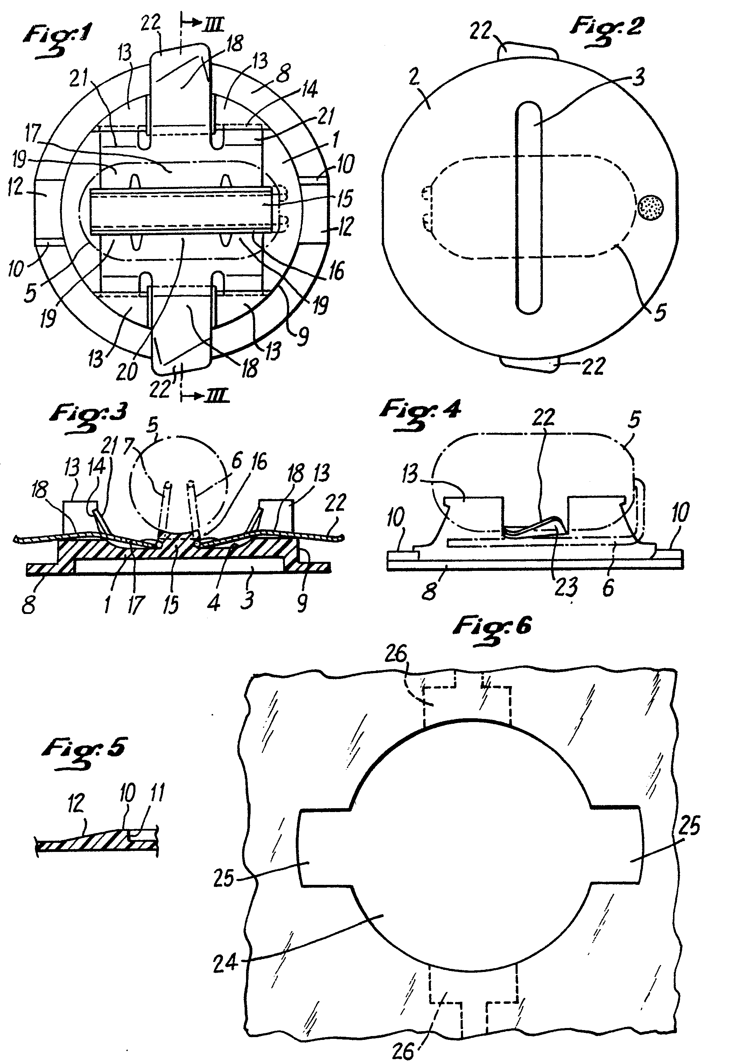

On comprend donc qu'il est ainsi possible d'encliqueter les éléments 17 en place comme on le voit sur les figures 1 et 3, chaque élément 17 prenant appui, par le côté interne ses pattes 19, 20, contre le fil 6 ou 7, préalablement placé dans le fond des rainures 16 du relief 15 alors que les pattes 21 pénètrent, sous tension élastique, dans les rainures 14, ce qui immobilise l'élément de contact 17 avec sa languette 18 passant radialement à travers le passage laissé entre les deux bossages 13 disposés de son côté. Ce faisant, chaque élément 17 est en contact électrique avec le fil 6 ou 7 de l'ampoule ou source lumineuse 5.

Les extrémités 22 des languettes 18 dépassent radialement le bord annulaire 9 et, comme on le voit notamment sur la figure 4, elles sont pliées à la façon de deux pales d'une hélice d'avion, pour former, sur leurs faces orientées vers la collerette 8, deux rampes 23 se rapprochant de la collerette 8 dans le sens horaire. Par ailleurs, on comprend que la mise en place des éléments 17, comme précité, a appliqué les languettes 18 qui les prolongent avec une tension élastique contre la face 4 du support.

Pour mettre en place un voyant sur une carte, on pratique dans celle-ci, par poinçonnage, un trou 24 de forme généralement circulaire avec un diamètre très légèrement supérieur au diamètre du bord 9, ce trou 24 se poursuivant cependant par deux encoches 25 diamétralement opposées et ayant une étendue radiale et tangentielle suffisante pour permettre le passage des extrémités 22 des languettes 18. Le circuit imprimé étant par exemple disposé horizontalement, avec ses pistes 26 portées par la face inférieure regardant le sol, on présente le voyant au-dessus de la face orientée vers le haut du circuit imprimé, la source lumineuse 5 et les languettes 18 étant orientées vers le bas. On introduit alors le voyant dans le trou 24 en faisant passer les extrémités 22 des languettes 18 dans les encoches 25, puis l'on provoque une rotation dans le sens anti-horaire. Les rampes 23 viennent alors au contact de la face inférieure du circuit imprimé et la poursuite de la rotation est autorisée du fait que les rampes 23 permettent aux languettes 18 de se soulever progressivement sous l'influence de l'épaisseur du circuit imprimé tandis que les reliefs 10 restent appliqués contre la face supérieure du circuit imprimé.

Lorsque la rotation s'est poursuivie sur un quart de tour, on comprend que les reliefs 10 viennent se présenter en face des encoches 25 et la sollicitation élastique des languettes 18 provoque alors l'enfoncement des reliefs 10 dans les encoches, de sorte que la collerette 8 vient s'appliquer contre la face supérieure du circuit imprimé tandis que les extrémités 22 se trouvent appliquées, de l'autre côté du circuit imprimé, contre les pistes conductrices 26, établissant alors la continuité électrique entre les pistes et la source lumineuse 5.

Dans cette position de blocage, toute poursuite de la rotation dans le même sens est impossible du fait que les faces 11 des reliefs 10 viennent buter contre le bord correspondant de l'encoche 25. Par contre, une rotation dans le sens inverse, c'est-à-dire dans le sens horaire, est autorisée pour le démontage mais ne peut se produire que si l'on exerce sur le support 1 un couple suffisant pour vaincre la résistance opposée par l'appui élastique des languettes 18, grâce à l'effet de rampe que produit le contact de la rampe 12 avec le bord de l'encoche 25 opposé à celui disposé au voisinage de la face 11 du relief 10.

On comprend qu'on a ainsi pu réaliser un voyant facile à fabriquer en très grande série, composé tout simplement d'un support qui peut facilement être moulé, de deux éléments de contact métalliques estampés et d'une ampoule ou autre source lumineuse.

Bien entendu, l'invention peut faire l'objet de différentes variantes normalement accessibles à l'homme de l'art. Ainsi, le nombre et la forme des languettes et des reliefs de blocage peuvent varier. De même, la fonction de la collerette 8 peut être remplie par des bras radiaux disposés à sa place. Le détail du montage et de l'encliquetage des éléments de contact 17 peut également varier, de même que, plus généralement, les différentes formes de réalisation de l'invention.

### Revendications

1. Voyant muni d'une source lumineuse (5) et de moyens de fixation destinés à permettre sa fixation sur un circuit imprimé tout en assurant simultanément la continuité électrique avec au moins deux pistes (26) du circuit destinées à alimenter le voyant, ledit voyant comportant un support isolant (1) définissant un bord annulaire cylindrique (9) dont le diamètre est légèrement inférieur au diamètre d'un poinçonnage (24) correspondant pratiqué dans le circuit imprimé, ledit support (1) étant muni à côté dudit bord (9), d'un prolongement radial (8) destiné à s'appuyer contre celle des faces du circuit imprimé qui ne présente pas lesdites pistes (26), ledit support (1) supportant, de l'autre côté du bord annulaire (9) au moins deux languettes métalliques conductrices (18) disposées sensiblement radialement et susceptibles d'être mises en contact avec les bornes (6, 7) de la source lumineuse (5) supportée par ledit support (1) lesdites languettes (18) dépassant radialement ledit bord annulaire (9) pour former deux extrémités radiales (22) susceptibles de traverser le poinçonnage (24) pratiqué dans le circuit imprimé grâce à des encoches radiales (25) du poinçonnage, la rotation du support (1) amenant alors les extrémités des languettes (22) au contact de la face du circuit imprimé portant les pistes (26) avec une déformation élastique des languettes tendant à maintenir le voyant serré sur le circuit imprimé, caractérisé en ce que ledit support isolant (1) présente la forme d'un disque aplati muni, au niveau de l'une de ses faces (2) d'une collerette sensiblement circulaire (8) s'étendant latéralement et sur son autre face (4) de reliefs (13, 14) immobilisant des éléments métalliques de contact (17) formant lesdites languettes métalliques conductrices (18) et comportant, outre la languette (18) une partie centrale (20) s'étendant obliquement vers le bas sur ladite surface (4) et venant bloquer, sur le support, des fils libres (6, 7) de la source lumineuse (5) disposée sur ladite face (4) et former une continuité électrique entre lesdits fils et lesdites languettes (18).

2. Voyant selon la revendication 1, caractérisé en ce que lesdites languettes (18) sont présentées chacune par un élément de contact métallique (17) susceptible d'être mis en contact électrique avec les fils (6, 7) de la source lumineuse (5) et fixé sur le support (1) par encliquetage.

3. Voyant selon la revendication 2, caractérisé en ce que ledit élément de contact métallique (17) présente une pluralité de pattes (19, 20, 21) permettant son encliquetage entre des rainures ou reliefs présentés, d'une part, par des bossages (13) du support et, d'autre part, par un relief central (15) s'étendant diamétralement, lesdites pattes d'encliquetage (19, 20) venant bloquer les fils libres (6, 7) de la source lumineuse et former la continuité électrique.

4. Voyant selon l'une quelconque des revendications 1 à 3, caractérisé en ce que lesdites extrémités des languettes (28) sont inclinées de façon à former des rampes (23) coopérant avec le circuit imprimé pour faire passer lesdites extrémités (22) par-dessus le bord de l'encoche radiale de poinçonnage (25), puis au contact de la face correspondante du circuit imprimé.

5. Voyant selon l'une quelconque des revendications 1 à 4, caractérisé en ce qu'il est muni de moyens d'immobilisation en rotation (11, 12).

6. Voyant selon la revendication 5, caractérisé en ce que lesdits moyens d'immobilisation dans la position angulaire requise comportent des reliefs (10) disposés radialement en relief par rapport auxdits bords cylindriques (9) et angulairement décalés par rapport aux languettes élastiques (18) de façon à venir s'encliqueter dans les encoches de poinçonnage (25) du circuit imprimé sous l'action de rappel élastique desdites languettes (18).

7. Voyant selon la revendication 6, caractérisé en ce que lesdits reliefs (10) se raccordent auxdits prolongements radiaux (8) par une rampe inclinée (12) dans le sens de rotation inverse de celui permettant la mise en place du voyant sur le circuit imprimé.

**Claims**

1. An indicator light equipped with a light source (5) and attachment means adapted to permit its attachment to a printed circuit while simultaneously ensuring the electrical continuity with at least two tracks (26) of the circuit, which tracks are adapted to feed the indicator light, said indicator light comprising an insulating support (1) defining a cylindrical annular edge (9), the diameter of which is slightly smaller than the diameter of a corresponding hole (24) punched in the printed circuit, said support (1) being equipped, at the side of said edge (9), with a radial extension (8) adapted to bear against the face of the printed circuit, which does not have said tracks (26), said support (1) supporting, at the other side of the annular edge (9), at least two conducting metallic tongues (18) disposed substantially radially and adapted to be brought into contact with the terminals (6, 7) of the light source (5) supported by said support (1), said tongues (18) extending radially beyond said annular edge (9) to form two radial ends (22) adapted to pass through the hole (24) punched in the printed circuit thanks to radial recesses (25) of the punched hole, the rotation of the support (1) then bringing the ends of the tongues (22) into contact with the face of the printed circuit carrying the tracks (26) with a resilient deformation of the tongues tending to hold the indicator light pressed against the printed circuit, characterised in that said insulating support (1) has the shape of a flattened disc equipped, at the level of one of its faces (2) with a substantially circular flange (8) extending laterally, and on its other face (4), with reliefs (13, 14) immobilising metallic contact elements (17) forming said conducting metallic tongues (18) and comprising, apart from the tongue (18), a central portion (20) extending obliquely downwards on said surface (4) and coming to lock, on the support, free wires (6, 7) of the light source (5) disposed on said face (4) and to form an electrical continuity between said wires and said tongues (18).

2. An indicator light as claimed in claim 1, characterised in that said tongues (18) are each produced by a metallic contact element (17) adapted to be brought into electrical contact with the wires (6, 7) of the light source (5) and attached to the support (1) by snapping in.

3. An indicator light as claimed in claim 2, characterised in that said metallic contact element (17) has a plurality of lugs (19, 20, 21) permitting its catching between grooves or reliefs produced, on the on hand by bosses (13) of the support and, on the other hand, by a central relief (15) extending diametrically, said locking tabs (19, 20) coming to lock the free wires (6, 7) of the light source and to form the electrical continuity.

4. An indicator light as claimed in any one of claims 1 to 3, characterised in that said ends of the tongues (28) are inclined in such a manner as to form ramps (23) cooperating with the printed circuit to cause said ends (22) to pass over the edge of the radial recess punched out (25) then into contact with the corresponding face of the printed circuit.

5. An indicator light as claimed in any one of the claims 1 to 4, characterised in that it is equipped with means for holding against rotation (11, 12).

6. An indicator light as claimed in claim 5, characterised in that said means for holding in the required angular position comprise reliefs (10) disposed radially in relief in relation to said cylindrical edges (9) and angularly offset in relation to the resilient tongues (18) in such a manner as to snap into the punched-out recesses (25) of the printed circuit under the resilient restoring action of said tongues (18).

7. An indicator light as claimed in claim 6, characterised in that said reliefs (10) are connected to said radial extensions (8) by a ramp (12) which is inclined in the opposite direction of rotation to that permitting the indicator light to be placed in position on the printed circuit.

**Patentansprüche**

1. Signallampe mit einer Lichtquelle (5) und mit Befestigungsvorrichtungen zu ihrer Befestigung auf einer gedruckten Schaltung und gleichzeitigen Herstellung einer elektrischen Leitungsverbindung mit mindestens zwei Leiterbahnen (26) der Schaltung zur Speisung der Signallampe, wobei die Signallampe einen Isolierträger (1) beinhaltet, der einen ringförmigen zylindrischen Rand (9) aufweist, dessen Durchmesser geringfügig geringer ist als der Durchmesser einer entsprechenden Durchbrechung (24) in der Leiterplatte, wobei der Isolierträger (1) seitlich von seinem Rand (9) eine radiale Verlängerung (8) aufweist, die sich gegen diejenigen Flächen der Leiterplatte abstützt, die nicht die Leiterbahnen (26) bilden, und wobei dieser Isolierträger (1) auf der anderen Seite der Ringschulter (9) zumindest zwei leitfähige, metallische Zungen (18) trägt, die sich im wesentlichen radial erstrecken und die in Kontakt mit Anschlussklemmen (6, 7) der Lichtquelle (5) gebracht werden können, die auf dem Isolierträger (1) angeordnet ist, wobei diese Zungen (18) radial aus dem ringförmigen Rand (9) herausragen und so zwei radiale Ausläufer (22) bilden, die die Ausnehmung (24) in der Leiterplatte durch radiale Einschnitte (25) der Durchbrechung (24) durchqueren können, wobei die Verdrehung des Trägers (1) die Enden der Zungen (22) in Kontakt mit denjenigen Flächen der Leiterplatte bringen, die die Leiterbahn (26) bilden, und wobei die Zungen eine elastische Deformierung derart erfahren, dass die Signallampe fest auf der Leiterplatte gehalten wird, dadurch gekennzeichnet, dass der Isolierträger (1) in Form einer flachen Scheibe ausgebildet ist und in Höhe einer seiner Oberflächen (2) einen im wesentlichen ringförmigen Flansch (8) aufweist, der sich seitlich erstreckt, sowie auf einer anderen Seite (4) Vorsprünge (13, 14), die metallische Kontaktelemente (17) festsetzen, die die leitfähigen metallischen Zungen (18) bilden, und die, ausser der Zunge (18), einen zentralen Teil (20) aufweisen, der sich schräg nach unten zum Boden dieser Oberfläche (4) erstreckt und dabei Leitungsdrähte (6, 7) der Lichtquelle (5) auf dem Träger festsetzt, die auf dieser Oberfläche (4) angeordnet sind und dabei so eine elektrische Verbindung zwischen diesen Leitungsdrähten und den Zungen (18) herstellt.

2. Signallampe nach Anspruch 1, dadurch gekennzeichnet, dass die Zungen (18) jeweils aus einem metallischen Kontaktelement (17) gebildet sind, das in elektrische Verbindung mit den Drähten (6, 7) der Lichtquelle (5) gebracht werden kann und aus dem Träger (1) durch Einrasten befestigbar ist.

3. Signallampe nach Anspruch 2, dadurch gekennzeichnet, dass das metallische Kontaktelement (17) mehrere Abschnitte (19, 20, 21) aufweist, die das Einrasten in Nuten oder Vorsprünge gestattet, die einerseits in den Trägerteilen (13) des Isolierträgers eingebracht sind, und andererseits in einer zentralen Erhebung (15) sich diametral erstrecken, so dass diese Rastzungen (19, 20) die freien Leitungsdrähte (6, 7) der Lichtquelle festsetzen und die elektrische Verbindung herstellen.

4. Signallampe nach einem der Patentansprüche 1–3, dadurch gekennzeichnet, dass die Enden der Zungen (18) derart geneigt sind, dass sie Rampen (23) bilden, die mit der Leiterplatte so zusammenwirken, dass die Enden (22) den Rand der radialen Einschnitte in der Durchbrechung (25) nach oben passieren und dann in Kontakt mit der entsprechenden Seite der Leiterplatte gebracht werden können.

5. Signallampe nach einem der Patentansprüche 1–4, dadurch gekennzeichnet, dass Mittel (11, 12) zur Blockierung der Verdrehung vorgesehen sind.

6. Signallampe nach Patentanspruch 5, dadurch gekennzeichnet, dass diese Mittel zur Blockierung in der erforderlichen Winkelposition Vorsprünge (10) beinhalten, die radial vom zylindrischen Rand (9) angeordnet sind und relativ zu den elastischen Zungen (18) winkelmässig versetzt sind, derart, dass sie in die Einschnitte der Durchbrechung (25) der Leiterplatte unter der elastischen Rückstellwirkung der Zungen (18) einrasten.

7. Signallampe nach Anspruch 6, dadurch gekennzeichnet, dass diese Vorsprünge (10) aus dem radialen Flansch (8) über eine Rampe (12) hervorgehen, die gegensinnig zum Drehungssinn geneigt ist, wenn die Signallampe auf der Leiterplatte in ihre Position gebracht wird.

0 092 489

Fig.1

Fig.2

Fig.3

Fig.4

Fig.5

Fig.6

7